# EUROPEAN PATENT SPECIFICATION

(11) **EP 0 589 451 B1**
(45) Date of publication and mention of the grant of the patent: **02.12.1998**
(21) Application number: 93115350.6
(22) Date of filing: 23.09.1993
(51) Int. Cl.: G03F 7/004

(54) **Photoresist Compositiom**
Fotoresist-Zusammensetzungen
Composition formant photoréserve

(30) Priority: 24.09.1992 JP 254486/92; 14.12.1992 JP 332985/92; 18.01.1993 JP 5794/93
(43) Date of publication of application: 30.03.1994
(73) Proprietor: Sumitomo Chemical Company, Limited, Chuo-ku Osaka 541-8550 (JP)
(72) Inventor: Kusumoto, Takehiro, Takarazuka-shi (JP); Takeyama, Naoki, Settsu-shi (JP); Ueda, Yuji, Izumi-shi (JP); Ueki, Hiromi, Mishima-gun, Osaka (JP); Nakano, Yuko, Ibaraki-shi (JP)
(74) Representative: VOSSIUS & PARTNER

(56) References cited:
- EP-A- 0 388 343
- EP-A- 0 497 342
- DE-A- 3 325 022

## Description

The present invention relates to a photoresist composition suitable for use in e.g. far ultraviolet (including excimer laser) lithography.

Recently, with a rise in the integration level of integrated circuits, formation of patterns of submicron order is required. Particularly, excimer laser lithography is watched with interest because it enables production of 64 and 256 MDRAMs. As a result of such an alteration of light source, the following properties are demanded of the today's resists in addition to the hitherto required properties such as heat resistance, film thickness retention and profile:
(1) a high sensitivity to the light sources mentioned above, and
(2) a high resolution.

In view of the above-mentioned state of things, the so-called chemically amplification resist utilizing an acid catalyst and a chemically amplifying effect has been proposed. The characteristic feature of this resist consists in that the solubility in developing solution is made different between an area exposed to light and an area not exposed to light by a reaction caused by an acid catalyst which a photo-induced acid precursor generate upon irradiation with light. Due to this difference in solubility, a positive or negative photoresist is obtained.

In the prior chemically amplification resists, halogen compounds such as 2,4,6-tris(trichloromethyl)-s-triazine have widely been used as the photo-induced acid precursor. However, the system using a halogenized compound as a photo-induced acid precursor has been disadvantageous in that the acid generated is a readily diffusible hydrogen halogenide which diffuses into the unexposed area, too, and thereby makes it impossible to obtain a fine pattern.

JP-A-1-293339 and 3-223862 disclose a negative photoresist and a positive photoresist wherein is used a compound having a sulfonic acid ester group as a photo-induced acid precursor to generate an arylsulfonic acid, respectively. In these systems, the diffusion of acid into unexposed area can be prevented because the acid generated therein is resistant to diffusion. However, these systems are insufficient in sensitivity and resolution, and do not fulfil the required properties necessary for producing 64M and 256M DRAMs.

It is an object of the present invention to provide a negative photoresist composition and a positive photoresist composition exhibiting excellent sensitivity and resolution while retaining the excellence in other properties such as heat resistance, film thickness retention, coating characteristics and profile.

According to the present invention, there are provided a negative photoresist composition comprising an alkali-soluble resin, a crosslinking agent and, as a photo-induced acid precursor, at least one sulfonic acid ester represented by the following general formula (I): 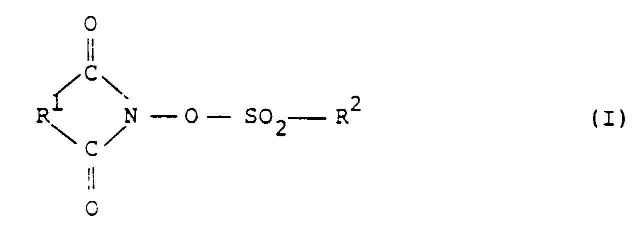 wherein R¹ represents an optionally substituted arylene, alkylene or alkenylene group and R² represents an optionally substituted alkyl or aryl group, provided that when R² is an alkyl or aryl group having a substituent, said substituent cannot be a fluorine atom; and a positive photoresist composition comprising an alkali-soluble resin, a dissolution inhibitor and, as a photo-induced acid precursor, at least one sulfonic acid ester represented by the above-mentioned general formula (I).

In the general formula (I) shown above, examples of the arylene group of R¹ include monocyclic and bicyclic arylene groups, among which phenylene and naphthylene are preferable. As preferable substituent present on the arylene group, a halogen atom, nitro group or acetylamino group can be referred to.

Examples of the alkylene group of R¹ include straight chain and branched chain alkylene groups, among which those having 1 to 6 carbon atoms are preferred and the ethylene group and propylene group are particularly preferred. As preferable substituent present on the alkylene group, a halogen atom, lower alkoxy group or monocyclic aryl group can be referred to.

Examples of the alkenylene group of R¹ include those having 2 to 4 carbon atoms, among which the vinylidene group is preferred. As preferable substituent present on the alkenylene group, monocyclic aryl groups can be referred to.

Examples of the alkyl group of R² include straight chain, branched chain and cyclic alkyl groups, among which straight chain alkyl groups having 1 to 8 carbon atoms are preferred. As preferable substituent present on the alkyl group, halogen atoms other than fluorine and lower alkoxy groups can be referred to.

Examples of the aryl group of R² include monocyclic and bicyclic ones, among which monocyclic aryl groups are preferred.

Preferable examples of the sulfonic acid ester represented by the general formula (I) include the following:

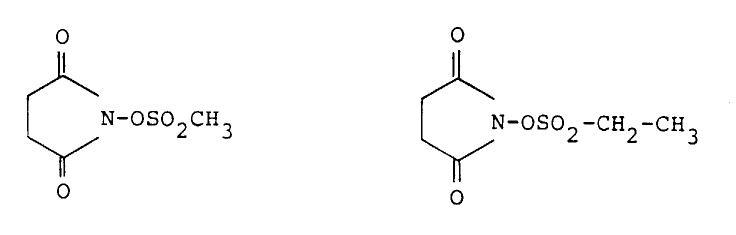

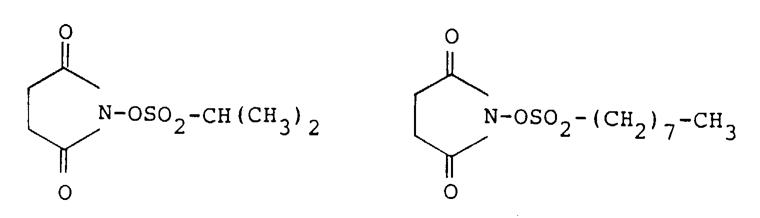

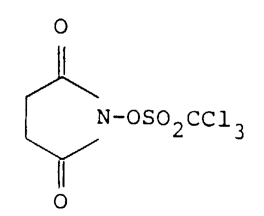

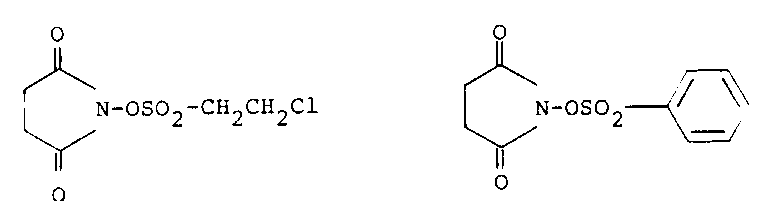

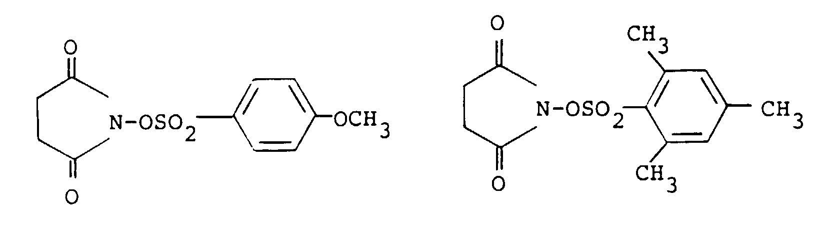

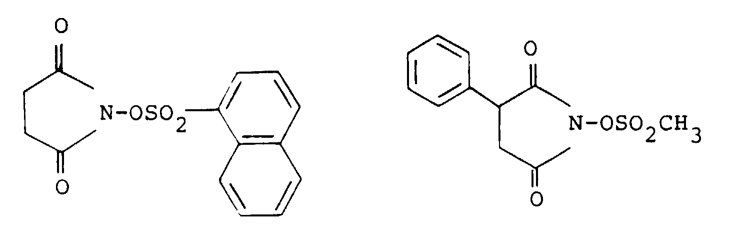

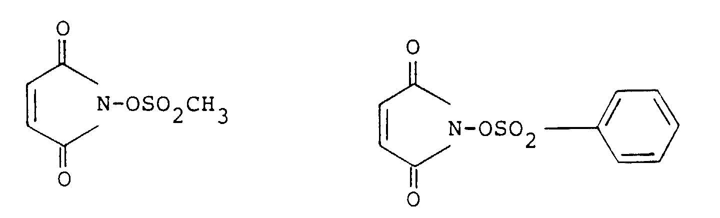

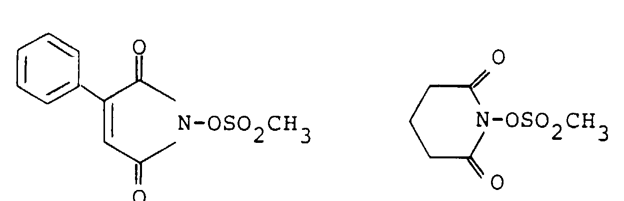

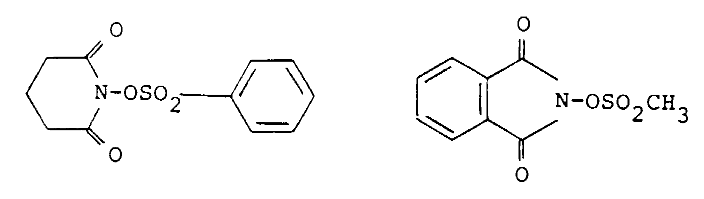

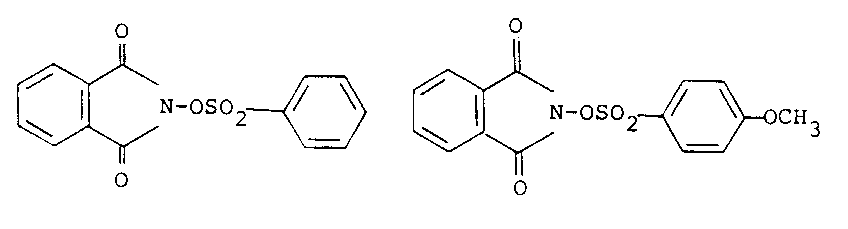

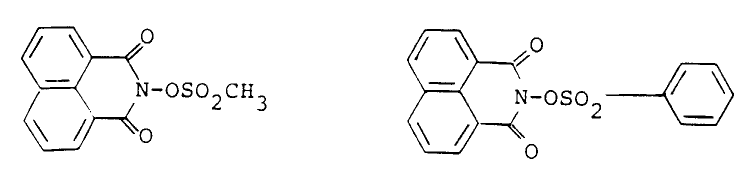

The sulfonic acid esters represented by the general formula (I) can be produced by reacting a cyclic N-hydroxyimide compound represented by the following general formula (II): 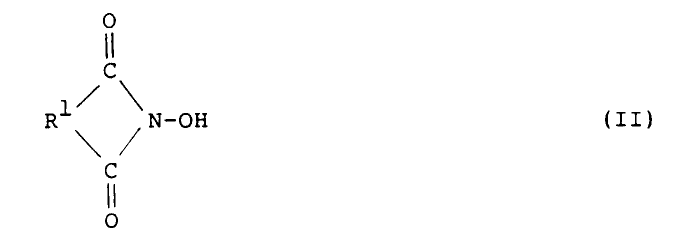 wherein R¹ is as defined above, which can be produced by the method mentioned in, for example, G. F. Jaubert, Ber., 28, 360 (1895), D. E. Ames et al., J. chem. Soc., 3518 (1955) or M. A. Stolberg et. al., J. Am. Chem. Soc., 79, 2615 (1957), etc. with a sulfonic acid chloride represented by the general formula R²-SO₂Cl, wherein R² is as defined above, under a basic condition according to the method mentioned in, for example, L. Bauer et al., J. Org. Chem., 24, 1293 (1959), etc.

The sulfonic acid ester represented by the general formula (I) is used either independently or in the form of a mixture of two or more compounds.

Examples of the alkali-soluble resin include the novolak resins obtainable through a condensation reaction of the compounds represented by the general formula (VI): 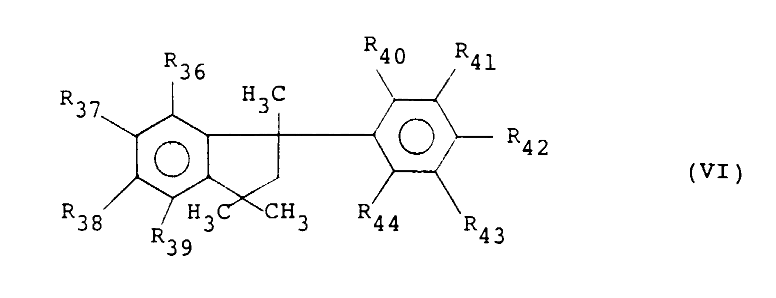 wherein R₃₆ to R₄₄ independently of one another each represents a hydrogen atom, a halogen atom, an optionally substituted straight chain or branched chain alkyl or alkenyl group, a hydroxyl group or an alkylcarbonyl group, provided that at least one of R₃₆ to R₄₄ is hydroxyl group and at least two of o- and p-positions of said hydroxyl group are hydrogen atom, with an aldehyde compound.

As the alkyl group represented by R₃₆ to R₄₄, those having 7 or less carbon atoms are preferred. As the substituent on said alkyl group, a halogen atom, -OH group or aryl group such as phenyl can be referred to. As the alkenyl group represented by R₃₆ to R₄₄, those having 7 or less carbon atoms are preferred. As the alkylcarbonyl group represented by R₃₆ to R₄₄, those having 7 or less carbon atoms are preferred. As the halogen atom represented by R₃₆ to R₄₄, chlorine and bromine are preferred.

Preferable examples of the compounds represented by the general formula (VI) are as follows:

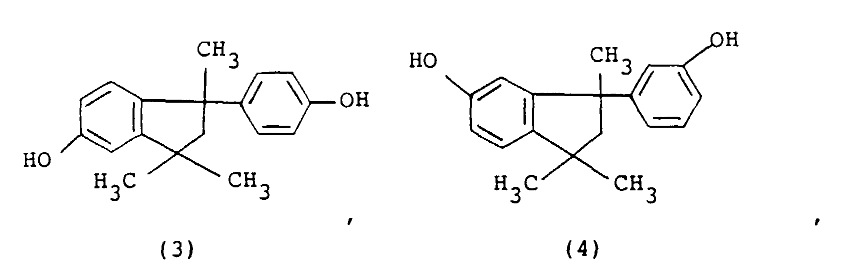

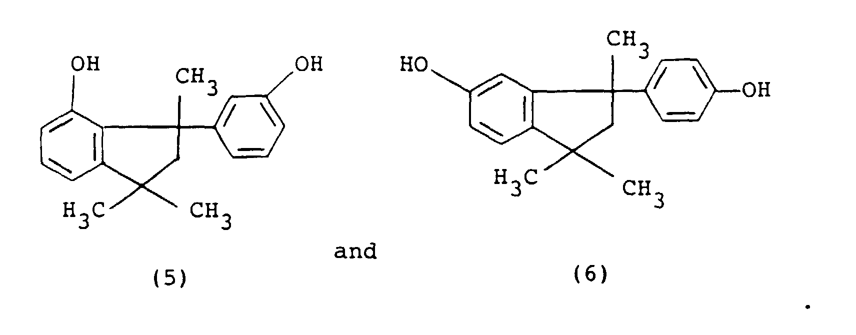

Further, examples of the alkali-soluble resin also include vinylphenol resins, isopropenylphenol resins, vinylphenol/styrene copolymers wherein the content of vinylphenol in the copolymer is preferably 50% by mole or above, and isopropenylphenol/styrene copolymers wherein the content of isopropenylphenol in the copolymer is preferably 50% by mole or above.

As measured by GPC method, the alkali-soluble resin has a polystyrene-converted weight average molecular weight of 1,000-10,000, preferably 1,500-8,000, and particularly preferably 2,000-5,000.

The alkali-soluble resin is used either independently or in the form of a mixture of two or more. Further, these resins and copolymers may also be used in the form of a mixture with a resin prepared by hydrogenating poly(vinylphenol).

The vinylphenol/styrene copolymer is preferably used in a negative photoresist composition, and a combination of said copolymer and a resin prepared by hydrogenating poly(vinylphenol) is more preferably used in a negative photoresist composition.

Examples of the crosslinking agent include the compounds having methylol groups or methylol ether groups represented by the general formula (VII): 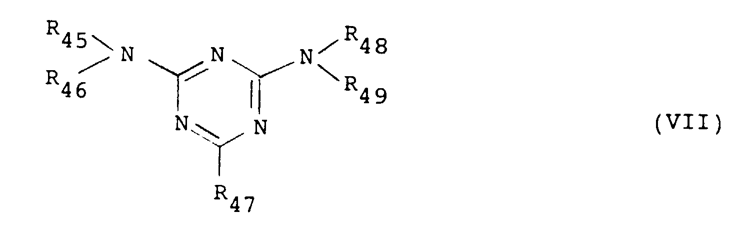 wherein R₄₇ represents an optionally substituted aryl group or a group of the following formula;

-N(R₅₀)(R₅₁),

R₄₅ to R₅₁ independently one another each represents a hydrogen atom, -CH₂OH or -CH₂OR₅₂, provided that at least one of R₄₅ to R₅₁ is -CH₂OH or -CH₂OR₅₂ and R₅₂ is an alkyl group.

As the aryl group represented by R₄₇, phenyl, 1-naphthyl and 2-naphthyl can be referred to. Examples of the substituent on said aryl group include a lower alkyl or alkokyl group, and a halogen atom. As the alkyl group represented by R₅₂, those having 4 or less carbon atoms are preferred.

Further, examples of the crosslinking agent also include the compounds such as those represented by the following formulas: 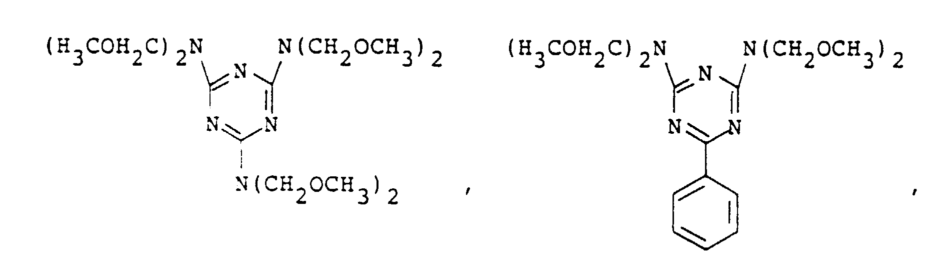 and

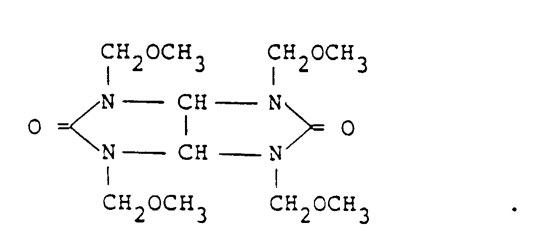

The crosslinking agent having methylol or methylol ether groups is used either independently or in the form cf a mixture of two or more.

Examples of the dissolution inhibitor include the compounds having a benzene ring substituted by a t-butoxycarbonyloxy group. Preferable examples of said compound include monocyclic and bicyclic compounds such as: 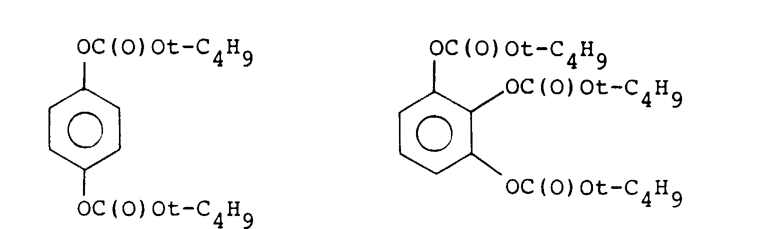 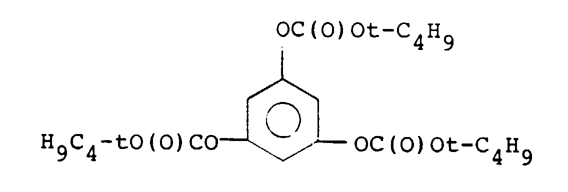 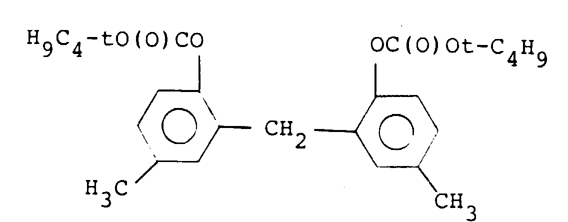 or the compounds represented by the following general formula (III): 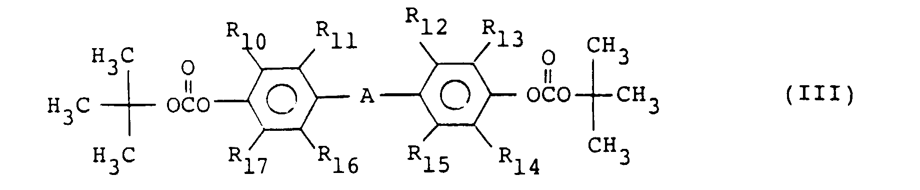 wherein R₁₀ to R₁₇ independently of one another each represents a hydrogen atom, a halogen atom, an optionally substituted straight chain or branched chain alkyl or alkenyl group or an optionally substituted alkylcarbonyl group, and A represents -O-, -SO₂- or optionally substituted alkylene group having 1-6 carbon atoms, and the like. Among these compounds, the compounds represented by the general formula (III) are more preferable.

The compound having benzene ring substituted by t-butoxycarbonyloxy group can be produced by reacting the corresponding compound having a benzene ring substituted by -OH group with di-t-butyl dicarbonate in the presence of a basic catalyst. As the basic catalyst, alkaline substances such as sodium hydroxide or potassium carbonate are preferably used. These basic catalysts can be used either in the form of a solid material such as granule, powder and the like or in the form of a solution in water or organic solvent, and preferably in the form of a solid. When the basic catalysts are used in the form of an aqueous solution, the concentration is usually 10-50% by weight and preferably 20-30% by weight. The basic catalyst and di-t-butyl dicarbonate are used usually in an amount of 1.1-2.2 equivalents (preferably 1.2-1.8 equivalents) and 1.0-2.0 equivalents (preferably 1.0-1.6 equivalents), respectively, both per equivalent of the -OH group in the compound having benzene ring substituted by -OH group.

The above-mentioned reaction is usually carried out in the presence of an organic solvent. Examples of the solvents usable in this reaction include ethers such as tetrahydrofuran, ketones such as acetone, halogenated hydrocarbons such as chloroform, and esters such as ethyl acetate, among which ethers are preferable. The organic solvent is used usually in an amount of 1-10 parts by weight and preferably in an amount of 3-6 parts by weight per part by weight of the compound having benzene ring substituted by -OH group. In the reaction mentioned above, phase transfer catalysts such as (n-C₄H₉)₄NHSO₄, crown ethers (for example, 18-crown-6) can also be used, and the amount of the phase transfer catalyst may be decided appropriately.

The reaction temperature is usually 10-50°C and preferably 15-30°C. The end point of the reaction is determined by detecting the time when the compound having benzene ring substituted by -OH group has disappeared by means of gas-, liquid- or thin layer-chromatography, for example.

Further, examples of the dissolution inhibitor also include the cyclic carbonate compounds represented by the following general formula (IV): 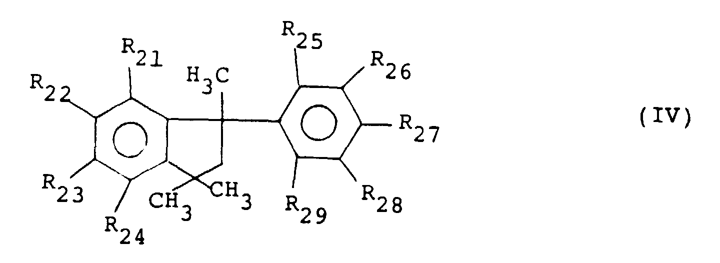 wherein R₂₁ to R₂₉ independently of one another each represents a hydrogen atom, a halogen atom, an optionally substituted straight chain or branched chain alkyl or alkenyl group, a t-butoxycarbonyloxy group or an acetyl group, provided that at least one of R₂₁ to R₂₄ is t-butoxycarbonyloxy group and at least one of R₂₅ to R₂₉ is t-butoxycarbonyloxy group.

As the alkyl or alkenyl groups represented by R₂₁ to R₂₉, those having 5 or less carbon atoms are preferred. As the substituent, for example, a halogen atom, -OH group, -SH group, phenyl group or lower alkylthio group can be referred to. As R₂₁ to R₂₉, hydrogen atom and alkyl group are preferable, and hydrogen atom, methyl group and ethyl group are more preferable.

The cyclic carbonate compound represented by the general formula (IV) can be produced by reacting a compound represented by the following general formula (V): 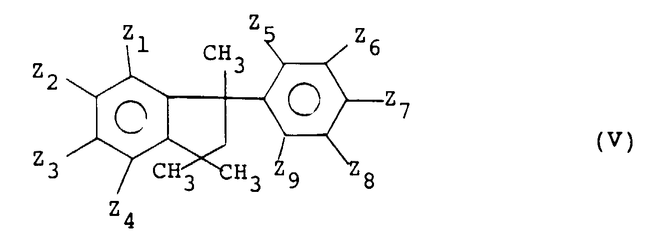 wherein Z₁ to Z₉ independently of one another each represents a hydrogen atom, a halogen atom, an optionally substituted straight chain or branched chain alkyl or alkenyl group, a -OH group or an acetyl group, provided that at least one of Z₁ to Z₄ is -OH group and at least one of Z₅ to Z₉ is -OH group, with di-t-butyl dicarbonate in the presence of a basic catalyst.

Preferable examples of the compound represented by the general formula (V) include the following:

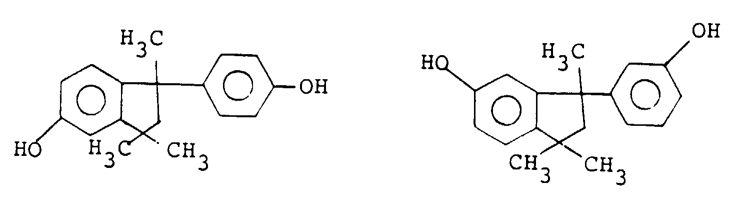

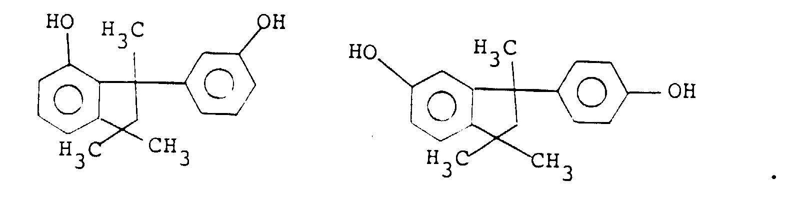

The compounds represented by the general formula (V) can be produced according to the method mentioned in US Patent No. 3,288,864 by using, for example, m- or p-isopropenylphenol or linear dimers thereof.

Preferable examples of the basic catalyst include alkaline substances such as sodium hydroxide or potassium carbonate. These basic catalysts can be used either in the form of a solid material such as granule or powder or in the form of a solution in water or organic solvent, and preferably in the form of a solid. When used in the form of an aqueous solution, the catalyst usually has a concentration of 10-50% by weight, preferably 20-30% by weight. The basic catalyst and di-t-butyl dicarbonate are used usually in an amount of 1.1-2.2 equivalents (preferably 1.2-1.8 equivalents) and 1.0-2.0 equivalents (preferably 1.0-1.6 equivalents), respectively, both per -OH group in the compound represented by the general formula (V).

The reaction mentioned above is usually carried out in the presence of an organic solvent. Examples of the solvent include ethers such as tetrahydrofuran, ketones such as acetone, halogenated hydrocarbons such as chloroform, and esters such as ethyl acetate, among which ethers are preferable. The amount of the organic solvent is usually 1-10 parts by weight and preferably 3-6 parts by weight, per part by weight of the compound represented by the general formula (V).

In the reaction mentioned above, a phase transfer catalyst such as (n-C₄H₉)₄NHSO₄ or a crown ether such as 18-crown-6 and the like may be used, and the amount of the phase transfer catalyst may be decided appropriately.

The reaction temperature is usually 10-50°C and preferably 15-30°C. The end point of the reaction is determined by detecting the point in time when the compound represented by the general formula (V) disappears by means of, for example, gas-, liquid- or thin layer-chromatography.

The preferred compounds are as follows: 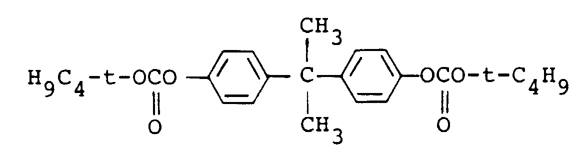 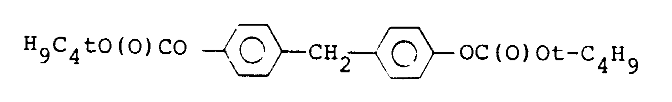 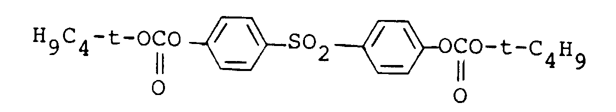 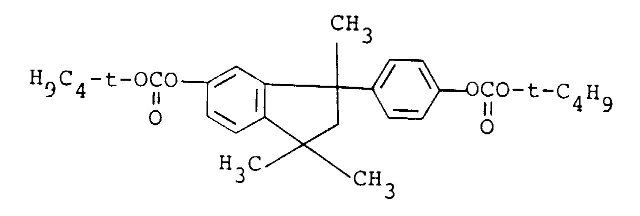 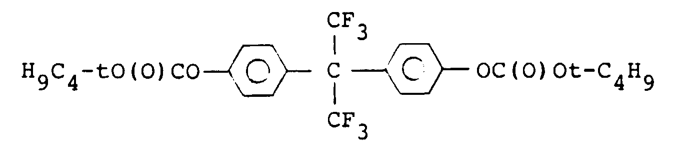 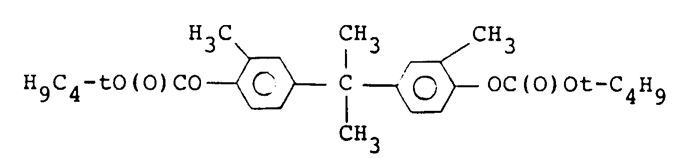 are preferably used.

These dissolution inhibitors are used either independently or in the form of a mixture of two or more compounds.

An electron donative compound may be added to the negative and positive photoresist compositions of the present invention. By addition of an electron donative compound, the decomposition of photo-induced acid precursor upon irradiation is accelerated, which results in an improvement of the sensitivity of photoresist.

As the electron donative compound, those of which first oxidation potential is lower than the first oxidation potential of phenol (+1.0 eV) which is a constitutional unit of the alkali-soluble resin are preferable. Examples of such electron donative compound include polycyclic aromatic compounds such as 4-methoxy-1-naphthol and β-naphthol and polycyclic aromatic heterocyclic compounds such as 2-hydroxycarbazole, carbazole and indoleacetic acid.

In the negative photoresist composition of the present invention, the alkali-soluble resin is used usually in an amount of 50-95% by weight (preferably 70 - 95% by weight), the crosslinking agent is used usually in an amount of 1-30% by weight (preferably 1 - 20% by weight), and the photo-induced acid precursor is used usually in an amount of 1-20% by weight (preferably 1 - 15% by weight), respectively. In the positive photoresist composition of the present invention, the alkali-soluble resin is used usually in an amount of 20 - 90% by weight (preferably 60 - 90% by weight), the dissolution inhibitor is used usually in an amount of 5 - 50% by weight (preferably 5 - 30% by weight) and the photo-induced acid precursor is used usually in an amount of 0.1 - 20% by weight (preferably 1 - 15% by weight), respectively. The electron donative compound is used usually in an amount of 0.001-5 part by weight (preferably 0.5 - 4 part by weight) per 100 parts by weight of negative or positive photoresist composition.

In any of the negative and positive photo-resist compositions of the present invention, various additives conventionally used in this field of the art, such as a sensitizer, a dye and an adhesion improver may be added, if necessary.

Usually, a photoresist solution is prepared by mixing the negative or positive photoresist composition into a solvent and adjusting the amount of the solvent so that the proportion of the photoresist composition in the resulting solution is 10-50% by weight.

Examples of the solvent usable for this purpose include methyl cellosolve acetate, ethyl cellosolve acetate, methyl cellosolve, ethyl cellosolve, propylene glycol monomethyl ether acetate, propylene glycol monoethyl ether acetate, propylene glycol monomethyl ether, propylene glycol monoethyl ether, diethylene glycol dimethyl ether, ethyl lactate, butyl acetate, ethyl pyruvate, 2-heptanone, cyclohexanone, methyl isobutyl ketone and xylene. The solvents are used either independently or in combination of two or more members.

The negative and positive photoresist compositions of the present invention are excellent in properties such as heat resistance, film thickness retention, coating characteristics and profile and further in sensitivity and resolution in the exposure light region using a far ultraviolet ray, including excimer laser, as a light source. Accordingly, in the lithography using the above-mentioned light sources, the photoresist compositions of the present invention can remarkably improve the resolution and contrast and thereby form a fine photoresist pattern with great accuracy.

Next, the present invention will be explained more concretely by examples which by no means intend to limit the invention. In the examples, parts are by weight, unless otherwise referred to.

### Referential Example 1

In 45 g of 5% aqueous solution of sodium carbonate, 3.5 g of N-hydroxysuccinimide was dissolved, to which 3.9 g of methanesulfonyl chloride was dropwise added at room temperature. After completion of the dropping, the reaction mixture was stirred at room temperature for 2 hours. Then, the mixture was poured into 300 ml of water, and the resulting crystalline precipitate was collected by filtration. After washing the crystalline precipitate until the washings reached neutral, the precipitate was recrystallized from acetone/hexane mixture to obtain N-hydroxysuccinimide methanesulfonate.

### Referential Example 2

N-Hydroxysuccinimide benzenesulfonate was obtained by repeating the procedure of Referential Example 1, except that the methanesulfonyl chloride was replaced with 6.0 g of benzenesulfonyl chloride and the recrystallization was carried out from acetone/water mixture.

### Referential Example 3

To a mixture of 100 g (0.37 mole) of a compound represented by the above-mentioned formula (6) (p-OST Cyclic Dimer, manufactured by Mitsui Toatsu Chemicals Inc.), 100 g of methyl isobutyl ketone, 13.6 g (0.0074 mole) of 5% aqueous solution of oxalic acid and 30 g (0.37 mole) of acetic acid was dropwise added 30.18 g (0.37 mole) of 37% formalin at 80°C over a period of one hour. After completing the dropping, the resulting mixture was reacted at 95-100°C for 20 hours. The reaction mixture was cooled to 60°C or below, added with 100 ml of deionized water and stirred, and left to stand. The separated oily layer was washed several times with each 100 ml portion of deionized water, the methyl isobutyl ketone was distilled off therefrom, and the residue was dissolved in ethyl cellosolve acetate to prepare a resin solution having a solid concentration of 40% (resin A). This resin had a polystyrene-converted weight average molecular weight of 3,975 as measured by the GPC method.

### Referential Example 4

A mixture of 12.6 g of melamine, 64.9 ml of 37% formalin and 50 ml of water was adjusted to pH 10 by adding 25% aqueous solution of potassium hydroxide. Then, the mixture was stirred at 60-70°C for 10 minutes. When the mixture had reached a white turbidity, the mixture was poured into 200 ml of cold methanol, and the resulting crystalline precipitate was collected by filtration. After washing with cold methanol, the crystal was dried under reduced pressure to obtain hexamethylolmelamine. Then, 0.5 ml of 1.8% hydrochloric acid was added to a mixture of 20 g of the hexamethylolmelamine and 200 ml of methanol. After a complete dissolution, the whole mixture was heated under reflux with stirring for 10 minutes, neutralized with 2.7% aqueous solution of potassium hydroxide, and filtered. The filtrate was concentrated under reduced pressure at a temperature not exceeding 50°C to obtain crude hexamethylolmelamine hexamethyl ether, of which purity was revealed to be 73% by HPLC analysis. Then, the crude hexamethylolmelamine hexamethyl ether was purified by silica gel column chromatography using n-hexane/acetone mixture (3/1) to obtain a purified sample of hexamethylolmelamine hexamethyl ether having a purity of 90%.

### Referential Example 5

To a mixture of 26.8 g (0.1 mole) of a compound represented by the formula (6) (p-OST Cyclic Dimer, manufactured by Mitsui Toatsu Chemicals Inc.) and 107 g of tetrahydrofuran, were added 48.0 g (0.22 mole) of di-t-butyl dicarbonate (manufactured by Wako Pure Chemical Industries Inc.), 36.5 g (0.26 mole) of potassium carbonate and 0.1 g of crown ether (18-Crown-6). After addition, the resulting mixture was reacted at room temperature for 24 hours. The reaction mixture was filtered, the filtrate was concentrated, and residue was dissolved in 300 g of ethyl acetate. The solution thus obtained was washed with water and concentrated to obtain a compound represented by the following formula (7):

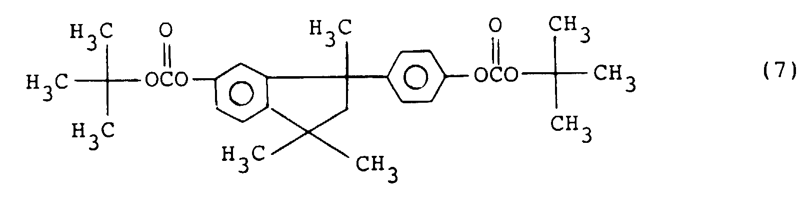

### Example 1

In 50 parts of diethylene glycol dimethyl ether were dissolved 13.5 parts of resin B [LYNCUR CST-70, manufactured by Maruzen Sekiyu Kagaku K. K., weight average molecular weight 2,900, p-hydroxystyrene/styrene copolymer (molar ratio 70/30)], 1.0 part of the purified hexamethylolmelamine hexamethyl ether obtained in Referential Example 4 (crosslinking agent) and 2.0 parts of N-hydroxysuccinimide methanesulfonate obtained in Referential Example 1 (photo-induced acid precursor). The resulting solution was filtered with a Teflon filter having a pore diameter of 0.2 µm to obtain a resist solution.

A silicon wafer which had been washed in the usual way was coated with the resist solution by means of a spinner so as to give a coating thickness of 0.7 µm. Then, the silicon wafer was pre-baked on a hot plate at 100°C for one minute. Then the pre-baked coating film was exposed to light through a patterned chromium mask with KrF Excimer Laser Stepper having an exposure wavelength of 248 nm (manufactured by Nikon Co., NSR-1755 EX8A, NA=0.45). After the exposure, the wafer was heated on a hot plate at 100°C for one minute to crosslink the exposed part, and then developed with 2.0% (by weight) aqueous solution of tetramethylammonium hydroxide to obtain a negative pattern. Observation of the formed pattern by means of an electron microscope revealed that a 0.25 µm fine pattern could be resolved, provided that exposure dose was 30 mJ/cm² (248 nm).

### Example 2

Example 1 was repeated, except that the N-hydroxysuccinimide methanesulfonate used in Example 1 as a photo-induced acid precursor was replaced with N-hydroxysuccinimide benzenesulfonate obtained in Referential Example 2. As a result, a fine pattern of 0.25 µm could be resolved.

### Example 3

In 39.2 parts of ethyl cellosolve acetate were dissolved 53.8 parts of the resin solution A obtained in Referential Example 3, 5 parts of the compound of the formula (7) obtained in Referential Example 5 and 2.0 parts of N-hydroxysuccinimide methanesulfonate obtained in Referential Example 1. The solution thus obtained was filtered with a Teflon filter having a pore diameter of 0.2 µm to prepare a resist solution. Then, a silicon wafer which had been washed in the usual way was coated with the resist solution by means of spinner so as to give a coating thickness of 0.7 µm. Then, the wafer was pre-baked on a hot plate at 100°C for one minute. Then, the pre-baked coating film was exposed to light through a patterned chromium mask with KrF Excimer Laser Stepper having an exposure wavelength of 248 nm (manufactured by Nikon Co., NSR-1755 EX8A, NA=0.45). After the exposure, the wafer was heated on a hot plate at 120°C for one minute and developed with 2.0% (by weight) aqueous solution of tetramethylammonium hydroxide to obtain a positive pattern. Observation of the pattern thus formed by means of an electron microscope revealed that fine patterns were resolved with a good profile.

### Example 4

In 50 parts of diethylene glycol dimethyl ether were dissolved 8.1 parts of resin B, 5.4 parts of resin C [MARUKA LYNCUR PHM-C, manufactured by Maruzen Sekiyu Kagaku K. K., weight average molecular weight 5,200], 1.0 part of the purified hexamethylolmelamine hexamethyl ether obtained in Referential Example 4 and 1.0 part of N-hydroxysuccinimide methanesulfonate obtained in Referential Example 1. The resulting solution was filtered with a Teflon filter having a pore size of 0.2 µm to obtain a resist solution.

Then, a silicon wafer which had been washed in the usual way was coated with the resist solution by means of spinner so as to give a coating thickness of 0.7 µm. Then, the wafer was pre-baked on a hot plate at 100°C for one minute. Then, the pre-baked coating film was exposed to light through a patterned chromium mask with KrF Excimer Laser Stepper having an exposure wavelength of 248 nm (manufactured by Nikon Co., NSR-1755 EX8A, NA=0.45). After the exposure, the wafer was heated on a hot plate at 105°C for one minute to make progress a crosslinking reaction, and developed with 2.0% (by weight) aqueous solution of tetramethylammonium hydroxide to obtain a negative pattern. Observation of the pattern thus formed by means of an electron microscope revealed that a 0.22 µm fine pattern could be resolved, provided that exposure dose was 24 mJ/cm² (248 nm).

### Example 5

In 50 parts of diethylene glycol dimethyl ether were dissolved 8.1 parts of resin B, 5.4 parts of resin C, 1.0 part cf hexamethylolmelamine hexamethyl ether, 1.0 part of N-hydroxysuccinimide methanesulfonate and 0.5 part of carbazole. The resulting solution was filtered with a Teflon filter having a pore size of 0.1 µm to prepare a resist solution. Thereafter, the procedure of Example 4 was repeated to obtain a negative pattern. Observation of the pattern thus formed by means of an electron microscope revealed that a 0.30 µm fine pattern was resolved, provided that exposure dose was 15 mJ/cm² (248 nm) and the depth of focus in a 0.30 µm line-and-space was 1.35 µm.

### Example 6

A negative pattern was formed by repeating Example 5, except that the amount of carbazole was altered to 0.25 part. Observation of the pattern thus formed by means of an electron microscope revealed that a 0.25 µm fine pattern was resolved, provided that exposure dose was 20 mJ/cm² (248 nm) and the depth of focus in a 0.25 µm line-and-space was 1.20 µm.

### Example 7

A negative pattern was formed by repeating Example 5, except that the carbazole was replaced with 4-methoxy-1-naphthol. Observation of the pattern thus formed by means of an electron microscope revealed that a 0.30 µm fine pattern was resolved, provided that exposure dose was 15 mJ/cm² (248 nm).

### Example 8

A negative pattern was formed by repeating Example 5, except that the carbazole was replaced with 2-hydroxycarbazole. Observation of the pattern thus formed by means of an electron microscope revealed that a 0.25 µm fine pattern was resolved, provided that exposure dose was 20 mJ/cm² (248 nm).

## Claims

1. A negative photoresist composition comprising an alkali-soluble resin, a crosslinking agent and at least one sulfonic acid ester represented by the general formula (I) as a photo-induced acid precursor: 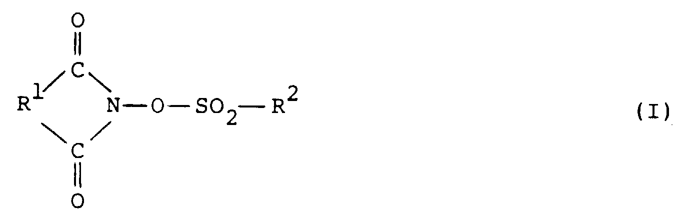 wherein R¹ represents an optionally substituted arylene, alkylene or alkenylene group; and R² represents an optionally substituted alkyl or aryl group, provided that when R² is an alkyl or aryl group having a substituent, said substituent cannot be a fluorine atom.

2. A positive photoresist composition comprising an alkali-soluble resin, a dissolution inhibitor and at least one sulfonic acid ester represented by the general formula (I) as a photo-induced acid precursor: 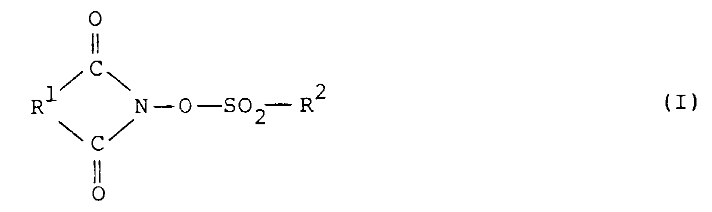 wherein R¹ represents an optionally substituted arylene, alkylene or alkenylene group; and R² represents an optionally substituted alkyl or aryl group, provided that when R² is an alkyl or aryl group having a substituent, said substituent cannot be a fluorine atom.

3. A negative or positive photoresist composition according to Claim 1 or 2, which contains an electron donative compound.

4. A negative or positive photoresist composition according to Claim 3, wherein the first oxidation-reduction potential of said electron donative compound is lower than 1.0 eV.

5. A negative or positive photoresist composition according to Claim 1 or 2, which contains, as an alkali-soluble resin, a novolac resin obtainable through a condensation reaction of a compound represented by one of the following formulas: 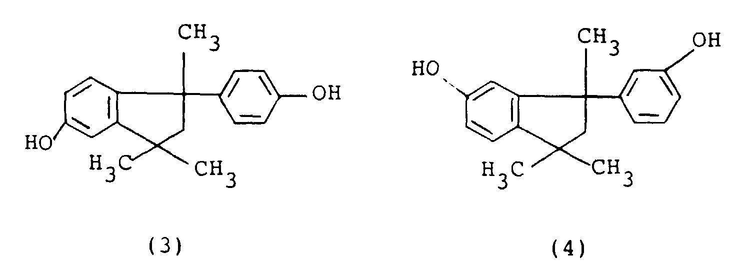 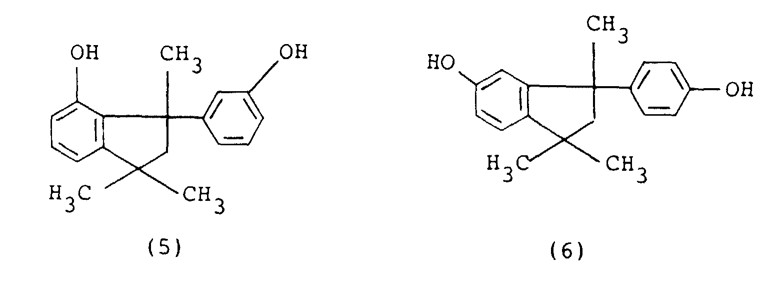 with an aldehyde compound, a vinylphenol resin, a isopropenylphenol resin, a vinylphenol/styrene copolymer or an isopropenylphenol/styrene copolymer.

6. A negative photoresist composition according to Claim 1, 3 or 4, which contains a vinylphenol/styrene copolymer as an alkali-soluble resin.

7. A negative photoresist composition according to Claim 6, which further contains a resin prepared by hydrogenating poly(vinylphenol) as an alkali-soluble resin.

8. A negative photoresist composition according to Claim 1, wherein said crosslinking agent is one of the following compounds: 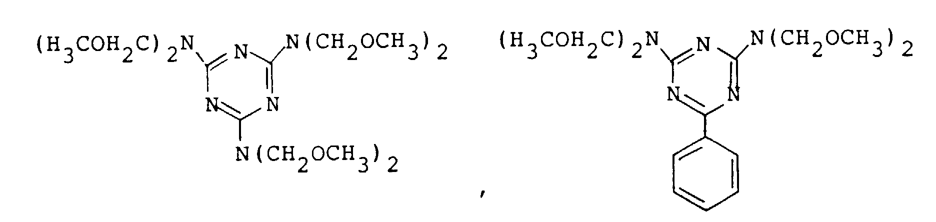 and

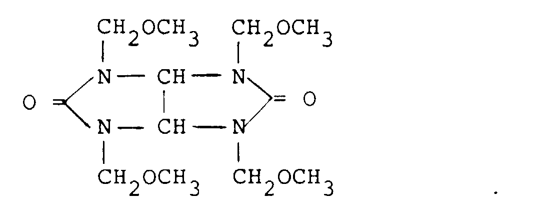

9. A positive photoresist composition according to Claim 2, wherein said dissolution inhibitor is one of the following compounds: 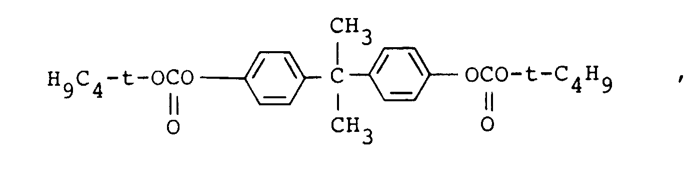 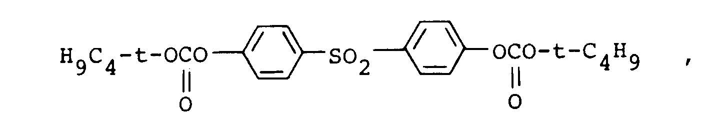 and

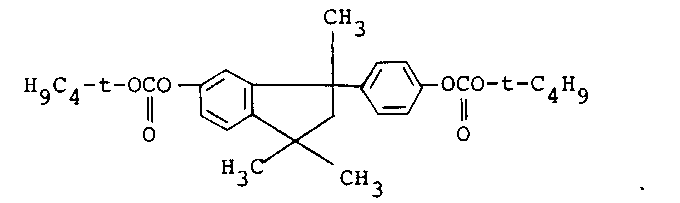

10. A negative or positive photoresist composition according to Claim 1 or 2, wherein said sulfonic acid ester represented by the general formula (I) as a photo-induced acid precursor is one of the compounds represented by the following formulas:

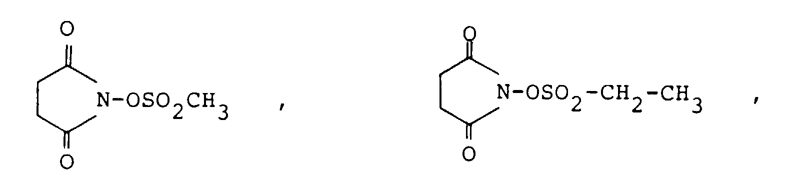

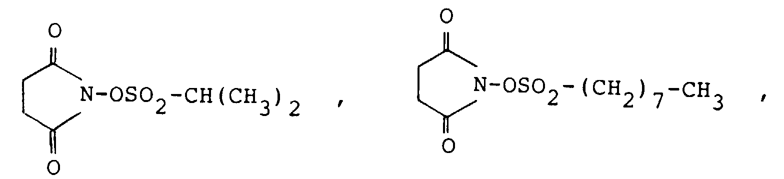

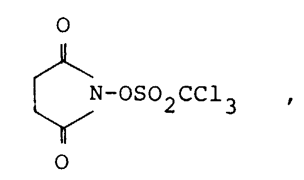

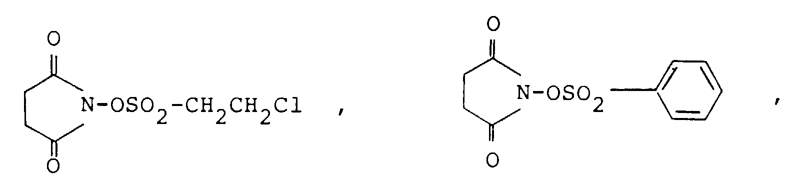

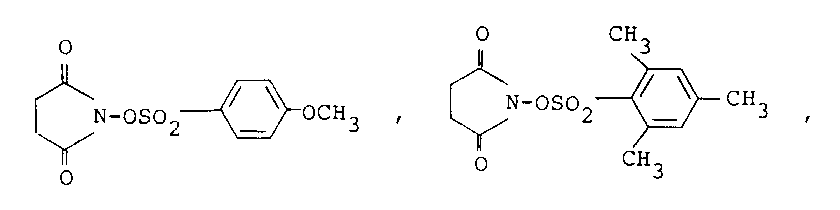

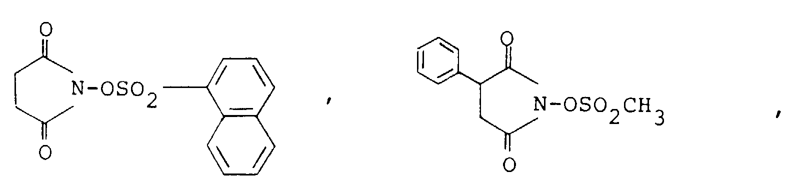

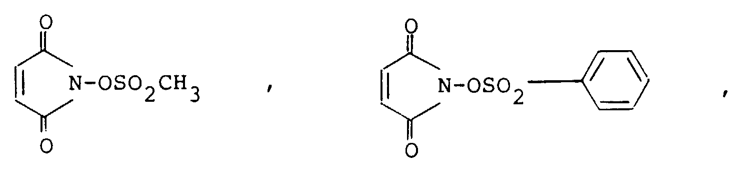

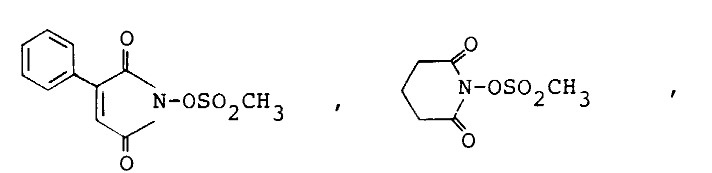

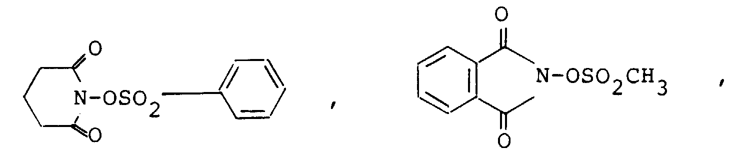

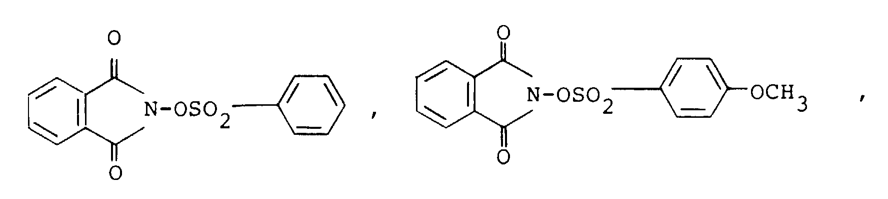

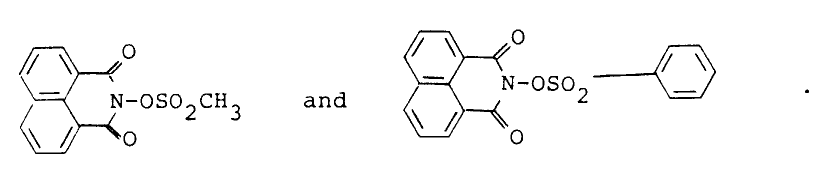

11. A negative photoresist composition according to Claim 1, wherein the ingredients are used at a ratio of 50 to 95% by weight of alkali-soluble resin, 1 to 30% by weight of crosslinking agent, and 1 to 20% by weight of photo-induced acid precursor.

12. A positive photoresist composition according to Claim 2, wherein the ingredients are used at a ratio of 20 to 90% by weight of alkali-soluble resin, 5 to 50% by weight of dissolution inhibitor, and 0.1 to 20% by weight of photo-induced acid precursor.

13. A negative or positive photoresist composition according to Claim 1 or 2, wherein the amount of the electron donative compound is 0.001 to 5 parts by weight per 100 parts by weight of the photoresist composition.

## Patentansprüche

1. Negative Photoresistzusammensetzung, umfassend ein basenlösliches Harz, ein Vernetzungsmittel und mindestens einen Sulfonsäureester der allgemeinen Formel (I) als photoinduzierte Säurevorstufe: 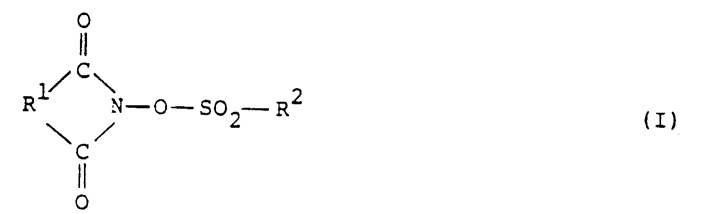 in der R¹ einen gegebenenfalls substituierten Arylen-, Alkylen- oder Alkenylenrest darstellt und R² einen gegebenenfalls substituierten Alkyl- oder Arylrest darstellt, mit der Maßgabe, daß, wenn R² ein Alkyl- oder Arylrest mit einem Substituenten ist, der Substituent kein Fluoratom sein kann.

2. Positive Photoresistzusammensetzung, umfassend ein basenlösliches Harz, einen Auflösungsinhibitor und mindestens einen Sulfonsäureester der allgemeinen Formel (I) als photoinduzierte Säurevorstufe: 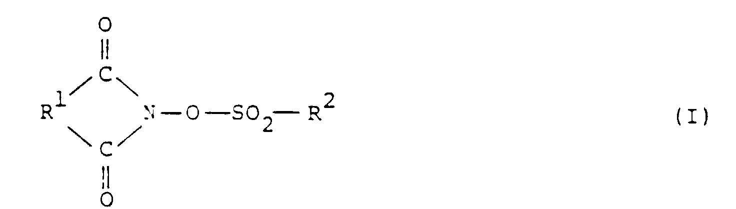 in der R¹ einen gegebenenfalls substituierten Arylen-, Alkylen- oder Alkenylenrest darstellt und R² einen gegebenenfalls substituierten Alkyl- oder Arylrest darstellt, mit der Maßgabe, daß, wenn R² ein Alkyl- oder Arylrest mit einem Substituenten ist, der Substituent kein Fluoratom sein kann.

3. Negative oder positive Photoresistzusammensetzung nach Anspruch 1 oder 2, die eine Elektronendonorverbindung enthält.

4. Negative oder positive Photoresistzusammensetzung nach Anspruch 3, in der das erste Oxidations-Reduktionspotential der Elektronendonorverbindung niedriger als 1,0 eV ist.

5. Negative oder positive Photoresistzusammensetzung nach Anspruch 1 oder 2, die als basenlösliches Harz ein Novolakharz enthält, das durch eine Kondensationsreaktion einer Verbindung, die durch eine der folgenden Formeln wiedergegeben wird: 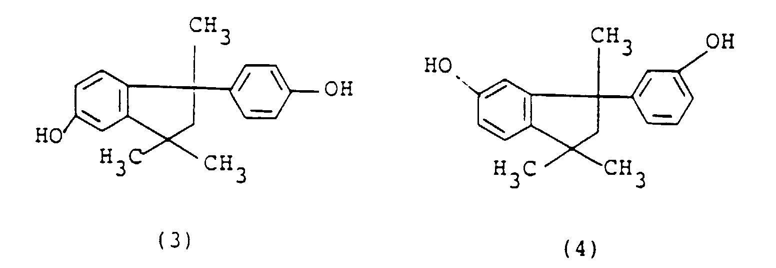 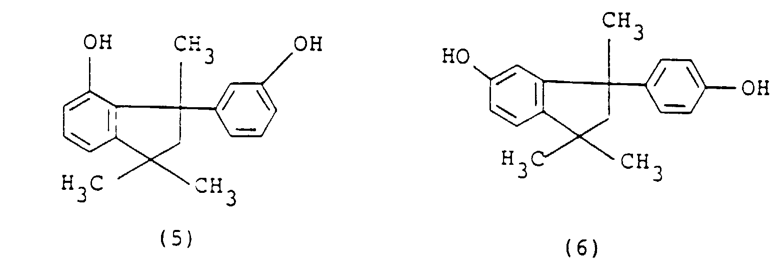 mit einer Aldehydverbindung, einem Vinylphenolharz, einem Isopropenylphenolharz, einem Vinylphenol/Styrol-Copolymer oder einem Isopropenylphenol/ Styrol-Copolymer erhältlich ist.

6. Negative Photoresistzusammensetzung nach Anspruch 1, 3 oder 4, die ein Vinylphenol/Styrol-Copolymer als basenlösliches Harz enthält.

7. Negative Photoresistzusammensetzung nach Anspruch 6, die ferner ein Harz, das durch Hydrieren eines Poly(vinylphenols) hergestellt wird, als basenlösliches Harz enthält.

8. Negative Photoresistzusammensetzung nach Anspruch 1, in der das Vernetzungsmittel eine der folgenden Verbindungen ist: 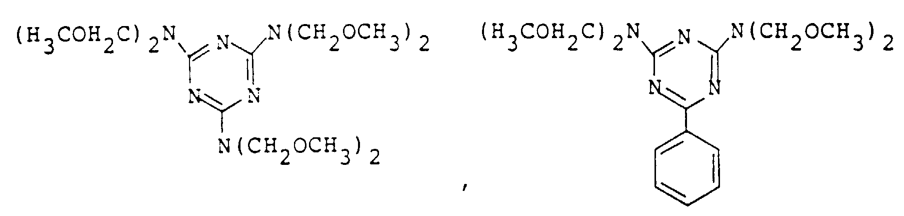 und

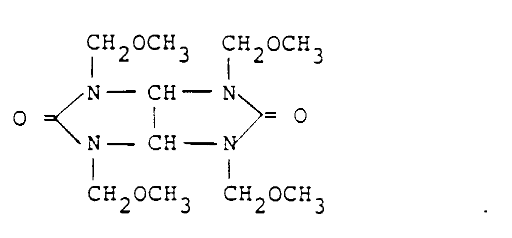

9. Positive Photoresistzusammensetzung nach Anspruch 2, in der der Auflösungsinhibitor eine der folgenden Verbindungen ist: 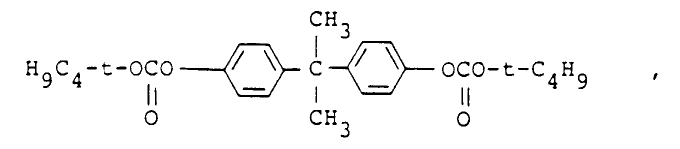 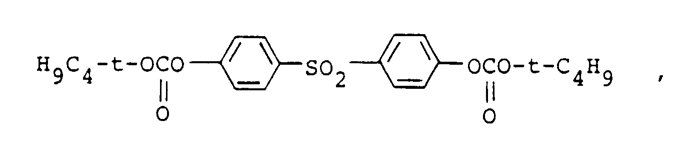 und

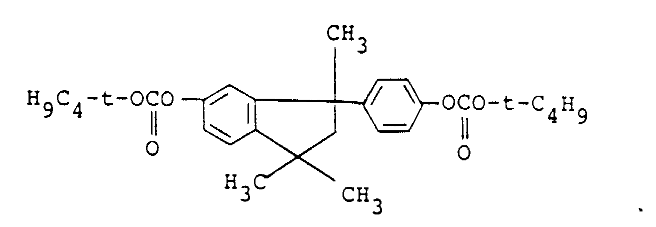

10. Negative oder positive Photoresistzusammensetzung nach Anspruch 1 oder 2, in der der Sulfonsäureester der allgemeinen Formel (I) als photoinduzierte Säurevorstufe eine der Verbindungen der folgenden Formeln ist:

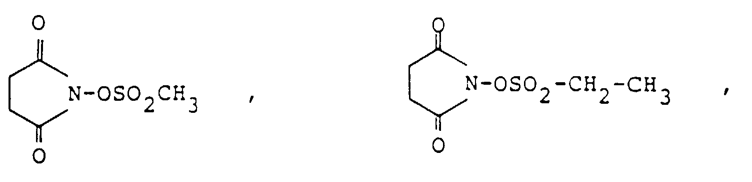

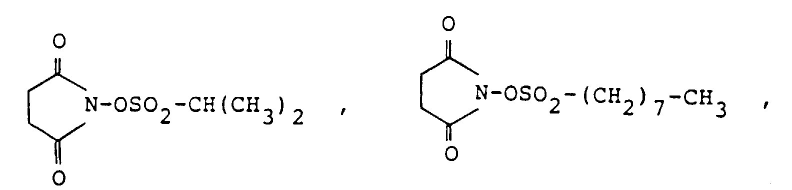

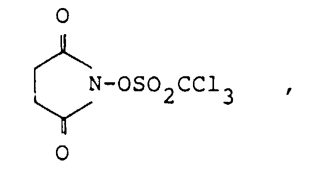

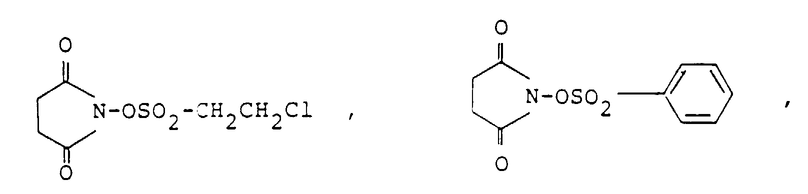

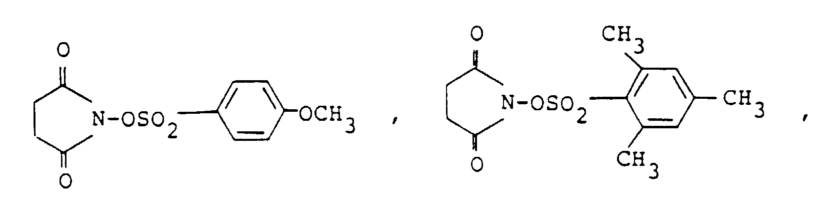

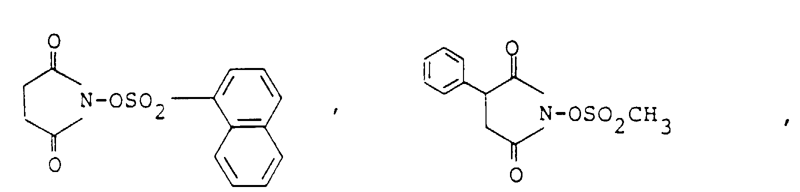

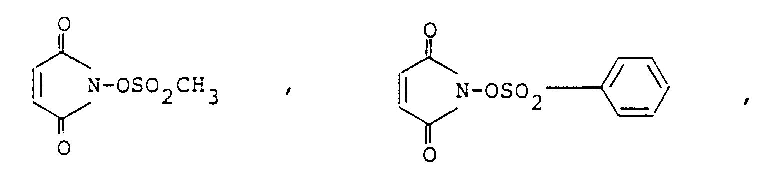

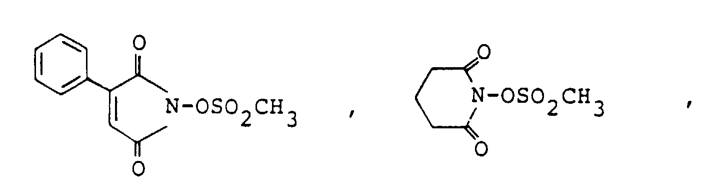

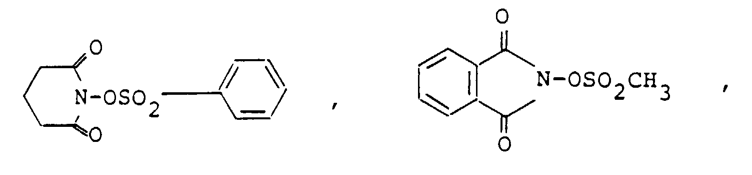

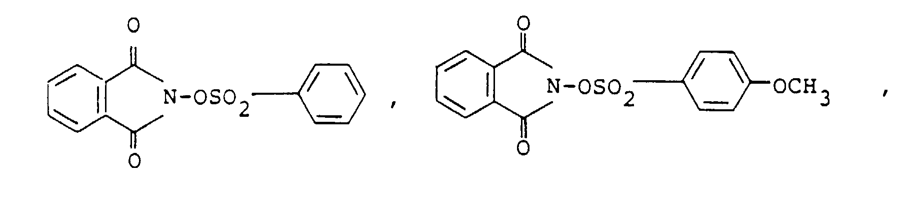

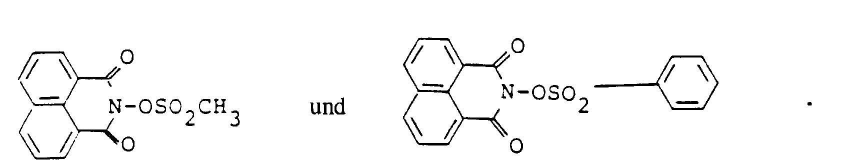

11. Negative Photoresistzusammensetzung nach Anspruch 1, in der die Bestandteile in einem Verhältnis von 50 bis 95 Gew.-% des basenlöslichen Harzes, 1 bis 30 Gew.-% des Vernetzungsmittels und 1 bis 20 Gew.-% der photoinduzierten Säurevorstufe verwendet werden.

12. Positive Photoresistzusammensetzung nach Anspruch 2, in der die Bestandteile in einem Verhältnis von 20 bis 90 Gew.-% des basenlöslichen Harzes, 5 bis 50 Gew.-% des Auflösungsinhibitors und 0,1 bis 20 Gew.-% der photoinduzierten Säurevorstufe verwendet werden.

13. Negative oder positive Photoresistzusammensetzung nach Anspruch 1 oder 2, in der die Menge der Elektronendonorverbindung 0,001 bis 5 Gew.-Teile, pro 100 Gew.-Teile der Photoresistzusammensetzung, beträgt.

## Revendications

1. Composition de photoresist négatif, comprenant une résine soluble dans un alcali, un agent de réticulation et au moins un ester d'acide sulfonique représenté par la formule générale (I) en tant que précurseur d'acide photo-induit : 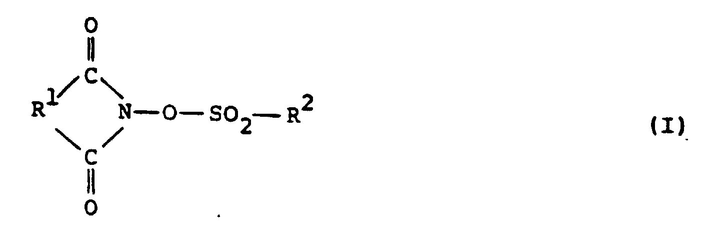 dans laquelle R¹ représente un groupe arylène, alkylène ou alcénylène facultativement substitué ; et R² représente un groupe alkyle ou aryle facultativement substitué, étant entendu que lorsque R² est un groupe alkyle ou aryle ayant un substituant, ledit substituant ne peut pas être un atome de fluor.

2. Composition de photoresist positif, comprenant une résine soluble dans un alcali, un inhibiteur de dissolution et au moins un ester d'acide sulfonique représenté par la formule générale (I) en tant que précurseur d'acide photo-induit : 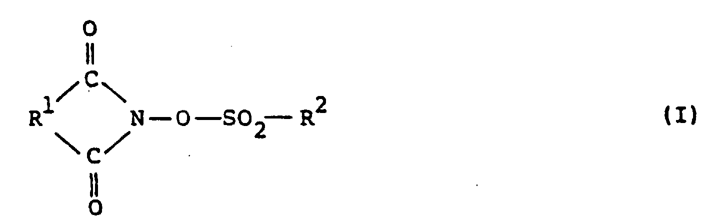 dans laquelle R¹ représente un groupe arylène, alkylène ou alcénylène facultativement substitué ; et R² représente un groupe alkyle ou aryle facultativement substitué, étant entendu que lorsque R² est un groupe alkyle ou aryle ayant un substituant, ledit substituant ne peut pas être un atome de fluor.

3. Composition de photoresist négatif ou positif selon la revendication 1 ou 2, qui contient un composé donneur d'électron.

4. Composition de photoresist négatif ou positif selon la revendication 3, dans laquelle le premier potentiel d'oxydoréduction dudit composé donneur d'électron est inférieur à 1,0 eV.

5. Composition de photoresist négatif ou positif selon la revendication 1 ou 2, qui contient, en tant que résine soluble dans un alcali, une résine novolaque pouvant être obtenue par une réaction de condensation d'un composé représenté par l'une des formules suivantes : 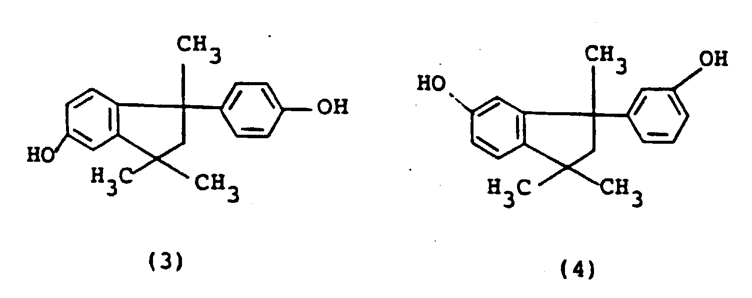 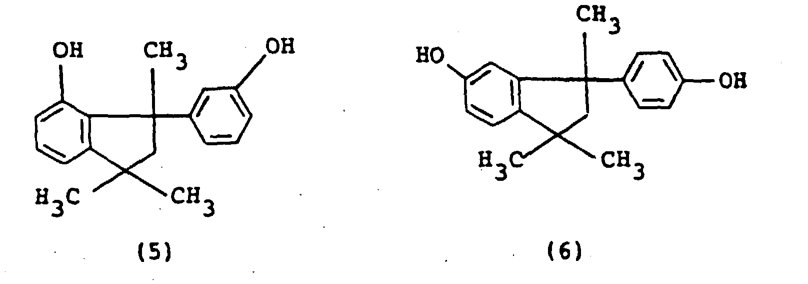 avec un composé aldéhyde, une résine vinylphénolique, une résine isopropénylphénolique, un copolymère vinylphénol/styrène ou un copolymère isopropénylphénol/styrène.

6. Composition de photoresist négatif selon la revendication 1, 3 ou 4, qui contient un copolymère vinylphénol/styrène en tant que résine soluble dans un alcali.

7. Composition de photoresist négatif selon la revendication 6, qui contient en outre une résine préparée en hydrogénant un poly(vinylphénol) en tant que résine soluble dans un alcali.

8. Composition de photoresist négatif selon la revendication 1, dans laquelle ledit agent de réticulation est l'un des composés suivants : 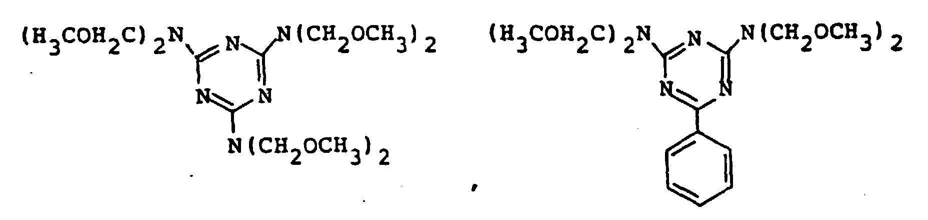 et

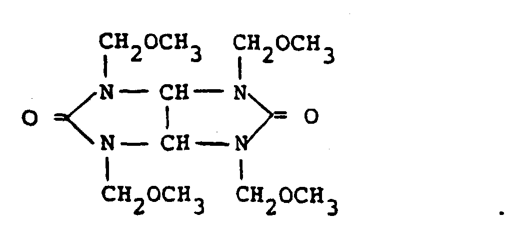

9. Composition de photoresist positif selon la revendication 2, dans laquelle ledit inhibiteur de dissolution est l'un des composés suivants : 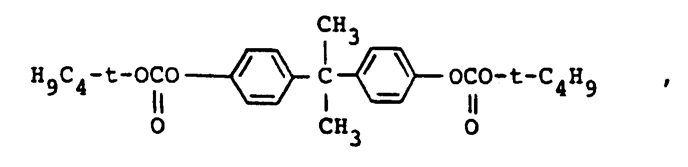 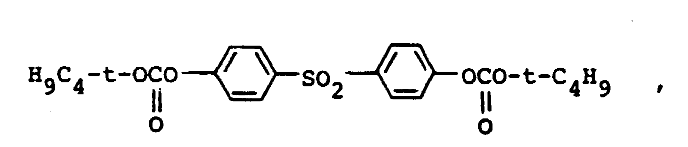 et

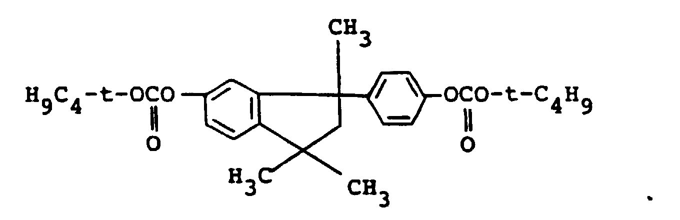

10. Composition de photoresist négatif ou positif selon la revendication 1 ou 2, dans lequel ledit ester d'acide sulfonique représenté par la formule générale (I) en tant que précurseur d'acide photo-induit est l'un des composés représentés par les formules suivantes :

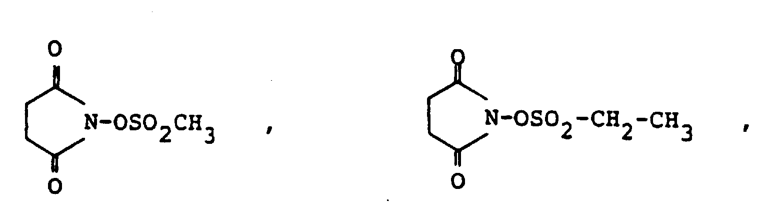

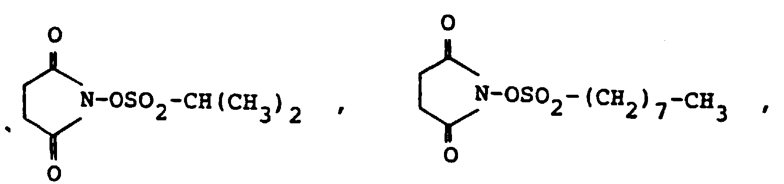

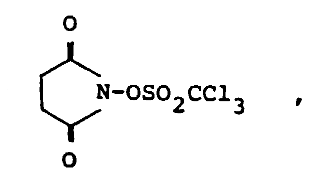

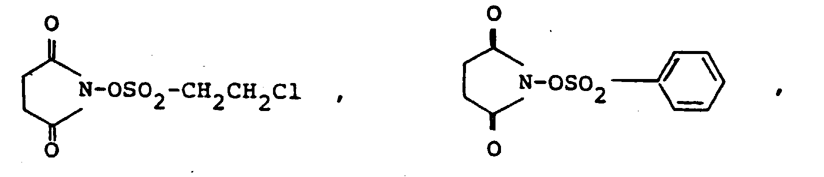

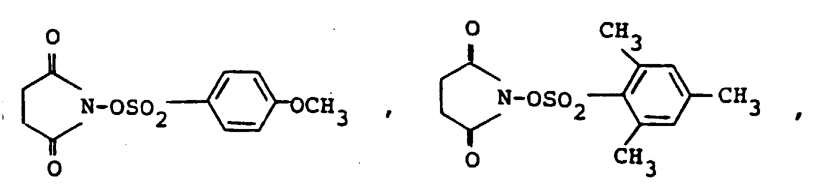

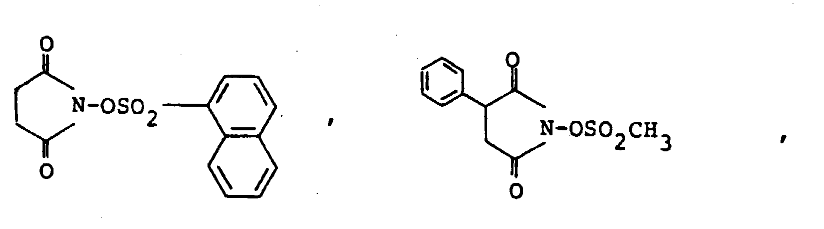

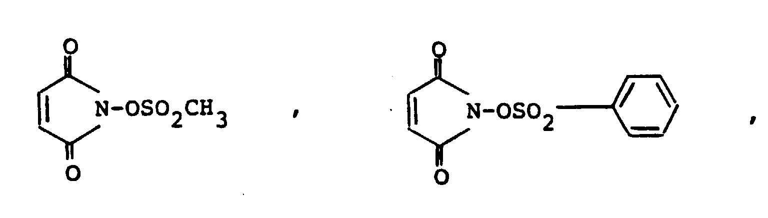

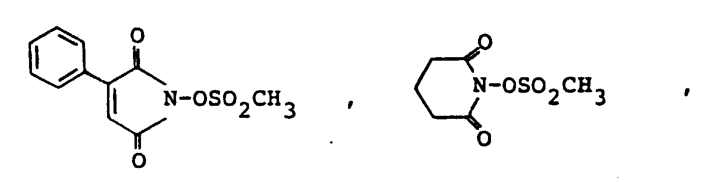

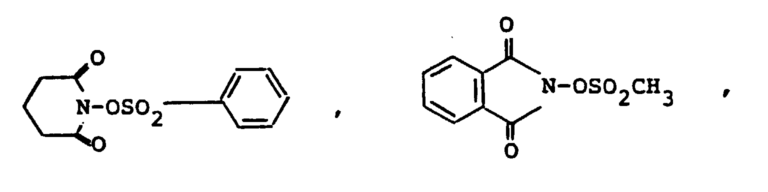

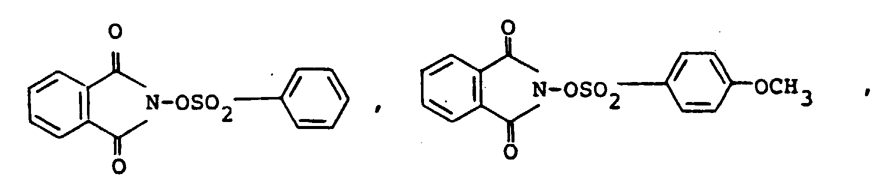

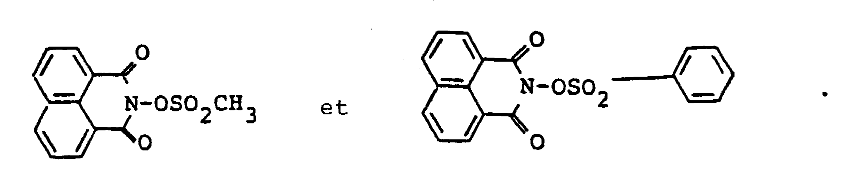

11. Composition de photoresist négatif selon la revendication 1, dans laquelle les ingrédients sont utilisés à une proportion de 50 à 95 % en poids de résine soluble dans un alcali, 1 à 30 % en poids d'agent de réticulation et 1 à 20 % en poids de précurseur d'acide photo-induit.

12. Composition de photoresist positif selon la revendication 2, dans laquelle les ingrédients sont utilisés à une proportion de 20 à 90 % en poids de résine soluble dans un alcali, 5 à 50 % en poids d'inhibiteur de dissolution et 0,1 à 20 % en poids de précurseur d'acide photo-induit.

13. Composition de photoresist négatif ou positif selon la revendication 1 ou 2, dans laquelle la proportion du composé donneur d'électron est de 0,001 à 5 parties en poids pour 100 parties en poids de la composition de photoresist.
